# EUROPEAN PATENT APPLICATION

(11) **EP 1 757 713 A1**
(43) Date of publication of application: **28.02.2007**
(21) Application number: 05750167.8
(22) Date of filing: 19.05.2005
(51) Int. Cl.: C23C 16/50, G02B 1/10

(54) **LENS-COATING GAS DISPENSER AND CORRESPONDING COATING DEVICE, LENS AND METHOD**

(30) Priority: 18.06.2004 ES 200401600
(71) Applicant: INDO Internacional, S.A., 08902 L'Hospitalet de Llobregat (Barcelona) (ES)
(72) Inventor: EGIO ARTAL, Alfonso, elona) (ES); VILAJUANA MAS, Antoni, E-08024 Barcelona (ES); GUTI RREZ BERASATEGUI, Eva, E-08006 Barcelona (ES); DÜRSTELER LÓPEZ, Juan Carlos, a) (ES); FERNÁNDEZ SERRANO, Ricardo, regat (Barcelona) (ES)
(74) Representative: Curell Aguilà, Marcelino
(86) International application number: PCT/ES2005/000278
(87) International publication number: WO 2006/000599

(57) **Abstract**

Gas distributor for coating a lens, and corresponding method, lens and coating device. The distributor comprises a flat outlet plate with a plurality of outlet holes having a distribution on the plate that is obtained as follows:
[a] defining an auxiliary surface,
[b] positioning first points on a first flat surface, with a constant superficial density of first points, where the first surface rests on the lower edge of the auxiliary surface, and
[c] drafting straight projection lines from a projection origin, and which intersect each of the first points, until they intersect the auxiliary surface, defining points on the auxiliary surface, and folded the projected points until they intersect the flat outlet plate, defining the position of the outlet holes.

## Description

### Field of the invention

The invention relates to a gas distributor for coating a lens, where the lens defines a surface to be coated and an optical axis. The invention also relates to a method for manufacturing a lens and a lens manufactured with said method. The invention also relates to a lens with a coating, preferably an anti-reflective (or interferential) coating and/or a coating consisting of a hardening layer. Another aim of the invention is a lens coating device, said device being of the CVD (Chemical Vapour Deposition) type.

### Prior art

Lens coating is known, particularly in ophthalmic lenses, with interferential layers that allow the reflection of the light incident on the lens to be reduced. To this end, a plurality of layers is deposited (preferably between 5 and 6) with thicknesses ranging between 10 and 120 nanometers. This is usually done using PVD (Physical Vapour Deposition) techniques, although it is possible to use other techniques such as CVD (Chemical Vapour Deposition), PE-CVD (Plasma Enhanced - Chemical Vapour Deposition), etc.

It is also known to treat the lenses by adding a hardening layer to them. This is particularly applicable to polymeric or organic lenses, as is frequently the case with ophthalmic lenses, because their scratching resistance is considerably lower than that of mineral lenses (usually called glass lenses). This coating is usually performed via inmersion in a siloxanic bath, and layers are obtained with thicknesses of approximately 2 or 3 microns

Both coatings can (and usually do) coexist for one and the same lens, although the methods for forming them are different, and therefore they have to be independent lens manufacturing stages. This means that the overall method is long (several hours) and expensive.

A very important requirement vis-à-vis these layers is that their thickness has to be very uniform. All currently known methods are seriously limited in this sense, and require complex technological solutions to obtain thickness dispersions that allow an acceptable vision quality.

In this specification and claims it must be understood that lens refers to any optical system made up of at least one surface and having dioptrical and/or catoptrical properties. In other words, any optical system based on refraction phenomena (dioptrical systems), such as for example ophthalmic lenses, and on reflection phenomena (catoptrical systems), such as for example optical mirrors. Also to be considered as lenses are those optical systems that combine both effects, such as for example, optical systems with an initial refracting surface and a second reflecting surface, optical systems with semi-transparent systems, etc.

### Summary of the invention

The invention is aimed at overcoming these drawbacks. This purpose is achieved by means of a gas distributor of the type indicated at the beginning, characterised in that it comprises a flat outlet plate with a plurality of outlet holes, the flat outlet plate having a defined plate centre and the distribution of the outlet holes over the plate being obtained as follows:
[a] defining an auxiliary surface, and positioning the auxiliary surface with respect to the flat outlet plate, with the auxiliary surface defining an outer perimeter,
[b] positioning first points on a first flat surface so that they are distributed with a constant superficial density of first points,
[c] positioning the first flat surface so that it is in contact with the perimeter and parallel to the flat outlet plate,
[d] for each first point:
   [d.1] drafting a straight projection line from a projection origin, on said optical axis, and which intersects the first point,
   [d.2] extending the straight projection line until it intersects the auxiliary surface, defining a projected point on the auxiliary surface,
   [d.3] drafting a folding line perpendicular to the flat outlet plate, from the projected point until it intersects the flat outlet plate, defining a second point
[e] making an outlet hole in each second point.

Effectively, one of the serious problems affecting lenses is that they are not flat surfaces, whereas the gas distributors usually have a flat outlet plate. For this reason, conventional gas distributors usually form gas densities and, generally, gas flows that are approximately uniform on planes parallel to the outlet plate. When the gases come into contact with the curved surface of the lens, every point of the lens is in contact with a different gas flow, and this causes irregular layer thicknesses. It is possible to design gas distributors that have an outlet plate that is not flat, but instead similar to the lens surface to be coated. However, these distributors are expensive and complex to manufacture. In the prior art, some gas distributors are known that have a flat outlet plate and a plurality of holes distributed irregularly to try and reduce the thickness dispersion of the layers to be deposited. However, it has been observed that the gas distributor according to the invention clearly obtains better results than the prior art gas distributors. The gas distributor according to the invention takes the gas flow into account as a vectorial magnitude, and takes into account the surface's three-dimensional geometry. In this way, not only is consideration given to the density of the gas flow at each point in space, but also to the incidence angle of the gas flow on the surface.

In order to manufacture the gas distributor, an auxiliary surface to be coated has to be defined. Effectively, the ideal situation would be where the gas distributor has been calculated and manufactured for the real lens that is to be coated. However, there are numerous real lenses, as it must be borne in mind that, for example in the case of ophthalmic lenses with some graduation, spherical, toric, progressive lenses, etc. can be combined, and each one with different powers. Therefore, for practical reasons, the gas distributor must be manufactured taking into account the fact that it must be suitable for coating a plurality of different surfaces. In this sense, an auxiliary surface must be defined (that will be an "average" surface in the range of surfaces that the distributor in question must be capable of coating). Logically, as mentioned before, this auxiliary surface will be preferably similar to the surface to be coated, as the more it resembles the real surface to be coated, the better the result obtained. On the other hand, from the point of view of the simplicity of the calculation, it is advantageous that the auxiliary surface be suitable for being described by an analytical expression, because analytical expressions allow a more simplified mathematical treatment. It must also be borne in mind that although ophthalmic lenses can be a combination of a plurality of surfaces, essentially they consists of a spherical surface. Therefore it is advantageous that the auxiliary surface be a spherical surface, as in the first approximation, this surface resembles most of the real ophthalmic lens surfaces. Although this does not rule out the possibility of the auxiliary surface being any other type of analytical surface (aspherical, toric, ellipsoidal surfaces, etc.) or even any other type of surface that is not necessarily analytical (such as for example, progressive surfaces expressed numerically or by means of other representation techniques for complex surfaces).

The positioning of the projection origin is a very important variable, because it is a parameter that defines the projecting of the first points of the first flat surface on the auxiliary surface and, therefore, determines the distribution of the second points.

The positioning of the surface to be coated with respect to the flat outlet plate is also very important and, in fact, it is a design variable that enables optimising the quality of the coatings obtained.

It must be taken into account that in this invention reference is made to two methods that must not be mixed up or confused: on the one hand, there is the method for determining the positions of the outlet holes (that is, the second points). To this end, an auxiliary surface is defined with an outer perimeter, a first surface and first points which will be used for carrying out the above-described projecting. However, these are all virtual elements, in other words, they do not physically exist and are only used to obtain a distribution of second points. On the other hand, the coating method relates to the coating of a real surface to be coated, which is arranged physically on a coating device and at a real distance from the distributor. In the coating method, the auxiliary surface and the remaining elements used during the method for determining the positions of the outlet holes do not have any physical meaning, and they are only associated with the coating method insofar as they influence the configuration of the distributor outlet plate. However, the fact that the auxiliary surface resembles (or even is the same as) the surface to be coated, allows to improve the results obtained, as mentioned above and as will be proved below.

The gas distributor according to the invention comprises a flat outlet plate, which is easy to construct and an outlet hole distribution that can be obtained by means of the above-mentioned method. By indicating that the distribution of holes can be obtained by means of the indicated method, it must be clear that this includes those cases wherein the distribution of outlet holes has been obtained by any other method, providing it could have been obtained by means of the above-indicated method.

As mentioned above, the first points are positioned on the first flat surface so that they have a distribution with a constant superficial density of first points. In fact, from a conceptual point of view, the method for re-distributing the first points in order to convert them into the second points, intends that the distribution of the second points enables a homogeneous projected flow onto the surface, taking into account the shape and distance of the surface to be coated.

Preferably the distribution of the first points on the first flat surface is defined by the knots in a square mesh, or by the knots in an equilateral triangular mesh.

In particular, the deposition process (through which the coating layers are formed) must take into account two phenomena affecting the uniformity of the thickness of the deposited layer. On the one hand, the distance between the surface to be coated and the outlet plate: the greater the distance, the slower the deposition speed. On the other hand, the angle between the surface to be coated and the speed of the gas jet out of the outlet holes: the smaller this angle, the slower the deposition speed. When coating a surface that is concave in the direction of the outlet plate, then both effects partially compensate each other. However, when the surface to be coated is convex towards the flat outlet plate, both effects accumulate. Therefore, the distributor according to the invention is particularly suitable for coating surfaces that are convex towards the distributor outlet plate, since the distributor has been calculated using an auxiliary surface that is also convex, and similar to the surface to be coated, therefore the distribution of the seconds points is such that it compensates the negative effects due to the convex shape of the surface to be coated.

Advantageously, the distance between the surface to be coated and the outlet plate is variable, such that it can be adjusted to different values according to certain criteria, such as for example as a function of the curvature radius of the surface to be coated. In fact, this distance has an important effect on the quality of the coating applied. It may be advisable to adjust this distance according to the real lens that it is desired to coat each time. The distance can be defined in various ways, such as for example, the distance between the optical centre of the lens surface and the centre of the plate, or any other definition that enables distances to be compared.

Advantageously the outlet holes have a diameter greater than 0.5 mm. It has been noted that with smaller holes, there is the risk that they become blocked because of the presence of pollutants. On the other hand, it is advantageous that there is a separation between the outlet holes, between 1 and 10 mm wide. Smaller separations would mean the holes superimposing one another, whereas larger separations would make the outflow of gas too irregular.

Advantageously, the outlet plate is between 50 and 100 mm in diameter, and preferably, it is made of a material included in the group comprising silver, copper and aluminium. These are good electricity conducting materials at the frequency, at which the equipment is used, which will usually be radio frequency, preferably 13.56 MHz. On the other hand, it is advisable that the materials have good mechanical properties and are easy to machine. In this sense, aluminium is particularly preferable. On the other hand, another preferable material is titanium, which has the added advantage that it has reduced sputtering (cathodic reduction). Preferably the flat outlet plate is between 1 and 2 mm thick.

The aim of the invention is also a method for manufacturing a lens, preferably an ophthalmic lens, characterised in that it comprises a coating stage in which a distributor according to the invention is used. Advantageously, both faces of the lens are coated simultaneously, and therefore a distributor according to the invention is used simultaneously for each lens face.

A further objective of the invention is a lens, preferably an ophthalmic lens, manufactured according to the method according to the invention.

The invention enables lenses to be obtained that have a curvature radius smaller than 350 mm in at least one of the points on its convex face and a coating on its convex face with a maximum thickness difference of between ± 2.5%. This thickness uniformity cannot be obtained with other lens coating techniques described in the prior art, and therefore an objective of the invention also includes lenses having a curvature radius less than 350 mm in at least one of the points on its convex face and a coating on its convex face with a maximum thickness difference of between ± 2.5%. Preferably the lens diameter (of the perimeter of the base) is greater than or equal to 50 mm, since it is really with larger diameter lenses that it is harder to obtain a uniform thickness, and it is in these cases that the invention represents a clearly significant improvement.

A further objective of the invention is a CVD type-coating device for lenses, characterised in that it comprises at least one distributor according to the invention. These devices enable coating thicknesses to be obtained between 5 and 3000 nanometers, and with physical characteristics (particularly a uniform thickness of the deposited layers) suitable for lenses, particularly ophthalmic lenses.

Preferably the coating device is of the PE-CVD type, as this type of technology makes it possible to work with lower temperatures (which makes it easier to apply it to coating organic lenses), and allows layers to be obtained that have a higher density and a larger refraction index (which is also easier to adjust), adhere better to the substrate and have greater resistance to abrasion. On the other hand, the PE-CVD coating technology requires working in less strength vacuum conditions than other technologies, which means avoiding possible dispersions in the characteristics of the coatings due to dispersions in the vacuum conditions of the process. Also, in this case the device according to the invention enables both faces to be coated simultaneously, and a hardening layer and interferential layers can be deposited in one and the same vacuum stage. Thanks to distributors being arranged according to the invention, it is possible to achieve all these results and, simultaneously, obtain low dispersions in the thickness of each layer, preferably below ± 2.5%.

Advantageously, the device comprises at least one radio frequency generator, in other words, it uses radio frequency for excitating the gases to be deposited. With regards to the alternative of using microwaves as an excitating source, radio frequency enables more uniform layers to be obtained, and requires less demanding vacuum conditions.

### Brief description of the drawings

Other advantages and characteristics of the invention will become apparent from the following description, in which, in a non-limiting manner, some preferable embodiments of the invention are explained, with reference to the accompanying drawings, in which:
Fig. 1 is a schematic view of the method for obtaining the position of the outlet holes on the flat outlet plate.
Fig. 2 is a plan view of a distribution of first points with a constant superficial density.
Fig. 3 is a plan view of a distribution of outlet holes according to the invention.
Fig. 4 is a graph showing the maximum thickness difference in the coated area of the lens, expressed in %, according to the curvature radius of the surface to be coated, expressed in mm, which is spherical.
Fig. 5 is a graph showing the value of the position of the projection origin, expressed in mm, according to the radius of the auxiliary surface, expressed in mm, which is spherical.
Fig. 6 is a graph showing the value of the optimum distance between the distributor and the outside perimeter of the surface to be coated, expressed in mm, according to the radius of the surface to be coated, expressed in mm, which is spherical.
Figs. 7 to 9 are graphs showing the value of the maximum thickness difference in the coated area of the lens, expressed in %, according to the radius of the surface to be coated, and according to different distributors used.
Fig. 10 is a schematic view of a first lens coating device according to the invention.
Fig. 11 is a schematic view of a second lens coating device according to the invention.
Fig. 12 is a schematic view of a distributor according to the invention.

### Detailed description of some embodiments of the invention

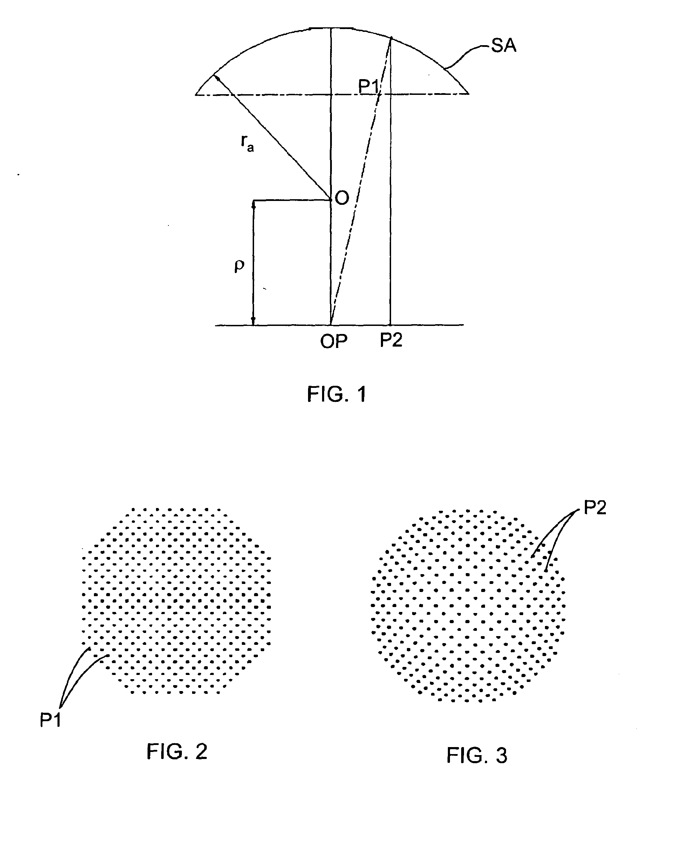

Fig. 1 is a schematic view of an example of the method followed for determining the positions of the outlet holes on the flat outlet plate of the gas distributor according to the invention. In this particular case, the auxiliary surface SA is a spherical surface having a radius rₐ. The auxiliary surface defines an optical axis, vertical in Fig. 1, which passes through the origin O of the sphere. Underneath the origin O, and at a distance p, the projection origin OP is positioned. The flat outlet plate is positioned so that it passes through the projection origin OP (generally this is not necessary, in other words, the flat outlet plate can be positioned so that it does not intersect the projection origin). On the basis of the spherical cap (which defines a perimeter that is a circumference), the first flat surface with the first points P1 is positioned so that the points have a constant superficial density (such as for example as shown in Fig. 2). From here a straight projection line is traced from the projection origin OP to each of the first points P1 and it is extended until it intersects with auxiliary surface SA, where a projected point is obtained. The projected point is projected again (or folded) perpendicular to the flat outlet plate, until it intersects the latter, defining a second point P2.

An example of a distribution of second points P2 can be seen in Fig. 3. This distribution has been obtained starting with a distribution of first points P1 such as that shown in Fig. 2 (which is a square mesh distribution where the points are separated 3 mm), defining auxiliary surface SA as a spherical convex cap having a curvature radius rₐ = 65.38 mm, diameter of the perimeter = 70 mm and taking ρ = -30 mm. These second points P2 are the ones, which define the positions of the outlet holes on the outlet plate.

As it can be seen, the example refers to a spherical auxiliary surface SA, in a flat outlet plate arranged parallel to the base of the spherical cap, such that the outside perimeter of the spherical cap is a circumference parallel to the flat outlet plate, and the flat outlet plate has been arranged so that it includes the projection origin. However, all these are particular cases and it is possible to use geometries other than those shown in the example in Fig. 1.

Also, the projection origin OP does not always have to be further from the auxiliary surface than the origin O, as it can also be between the auxiliary surface and the origin O. In other words, the value of ρ can be positive or negative.

In order to make it simpler to obtain experimental data, various numerical simulations have been carried out, which have predicted the behaviour of the distributor according to the invention. The following figures show the results obtained.

### Figure 4.

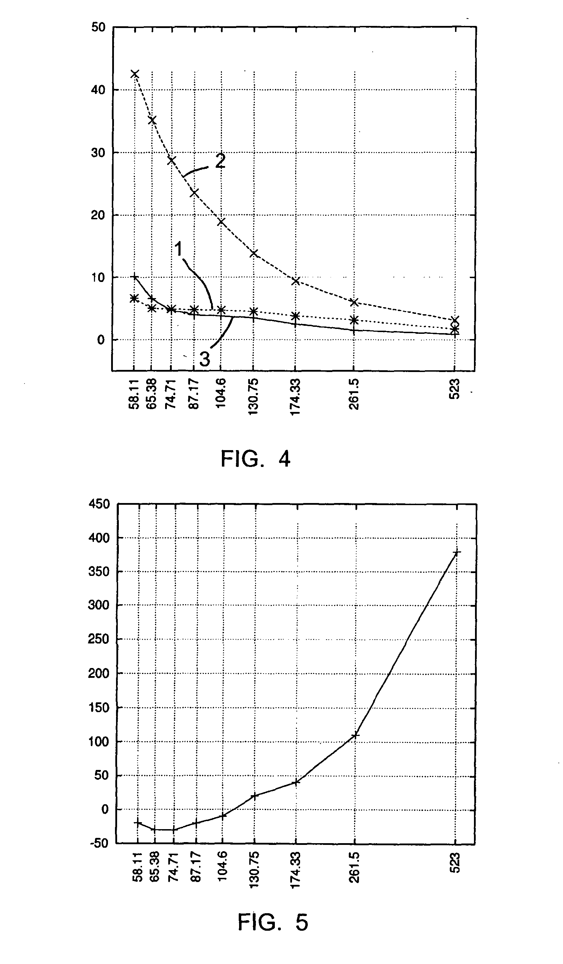

Fig. 4 shows the results of the following models:
- curve 1 shows the use of a conventional distributor, with a flat outlet plate having outlet holes distributed such that they have a constant superficial density, when the concave surface of an ophthalmic lens is coated.
- curve 2 shows the use of the curve 1 distributor when the convex surface of an ophthalmic lens is coated.
- curve 3 shows the use of a distributor according to the invention, when the convex surface of an ophthalmic lens is coated. This information has been obtained by considering that the auxiliary surface is a spherical cap, that the surface to be coated is also a spherical cap, and with the values rₐ, ρ and that for the distance between the flat outlet plate and the base of the surface to be coated, being shown in the following table 1:

**Table 1**

| r (mm) | rₐ (mm) | ρ(mm) | d(mm) |
|---|---|---|---|
| 58.11 | 58.11 | -20 | 25 |
| 65.38 | 65.38 | -30 | 20 |
| 74.71 | 74.71 | -30 | 20 |
| 87.17 | 87.17 | -20 | 20 |
| 104.6 | 104.6 | -10 | 20 |
| 130.75 | 130.75 | 20 | 20 |
| 174.33 | 174.33 | 40 | 15 |
| 261.5 | 261.5 | 110.0 | 15 |
| 523.0 | 523.0 | 380 | 15 |

In all cases, the diameter of the circumference forming the perimeter of the spherical cap was 70 mm.

These are the values that minimise the dispersion of thicknesses for each sphere radius of the lens to be coated.

It must be noted that in each case, the radius rₐ of the auxiliary surface coincides with the radius r of the surface to be coated. However, as mentioned above, the two surfaces must not be confused. This coincidence between both radii means that the case of extreme similarity has been considered between the auxiliary surface and the surface to be coated: both are identical.

### Figure 5.

The values of the parameter ρ are shown, which optimise the difference in thicknesses, indicated in Table 1, according to the sphere radii of the auxiliary surface (or, if preferred, according to the radii of the lens to be coated, as they are the same value.)

### Figure 6.

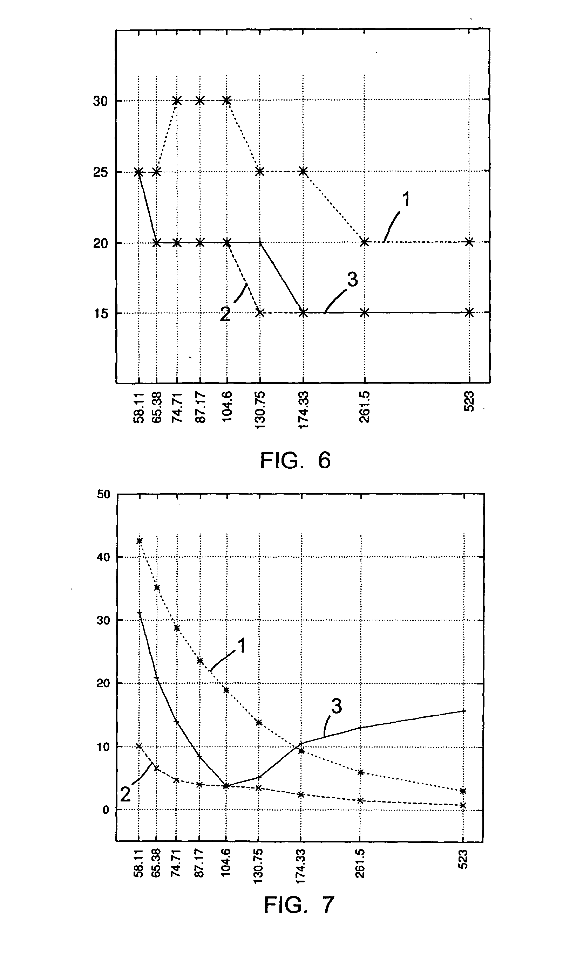

Figure 6 shows for each sphere radius of the surface to be coated, the distance between the flat outlet plate and the base of the spherical cap that minimises the dispersion of thicknesses. As it can be seen, it is possible to consider sphere radius groups which all have one and the same optimum distance. In this sense, it might be interesting to foresee that the ophthalmic lens coating device incorporates a mechanism that enables the distance between the flat outlet plate and the lenses to be coated to be varied according to the curvature radius of said lenses (or according to an equivalent parameter). Curves 1, 2 and 3 correspond to the curves in **Fig. 4.**

### Figure 7.

The auxiliary surface is the surface that has to be defined to enable the carrying out of the method for positioning the outlet holes. Optimally, this auxiliary surface coincides with the real surface of the ophthalmic lens to be coated, but this is more complex and expensive in practice. Therefore, it is advisable to choose an auxiliary surface which, being similar to the real ophthalmic lens to be coated, makes it possible to simplify the whole method. Preferably this auxiliary surface is similar to a plurality of real ophthalmic lenses, so that it can be used for coating a plurality of real ophthalmic lenses within required quality parameters. As it can be seen, the similar concept is not an exact concept, because the less the auxiliary surface resembles the real ophthalmic lens, the worse the results obtained, but an exact boundary cannot be defined because it will basically be an economic decision. The following comparative example is shown in Fig. 7:
Curve 1 shows the maximum difference in thicknesses, according to the sphere radius of the surface to be coated, when using a flat outlet plate with a constant density distribution of points to coat the convex surface of an ophthalmic lens. In fact, said curve 1 corresponds to curve 2 in Figure 4.
Curve 2 shows the curve 3 in Fig. 4, in other words, when each lens with a certain radius has been coated using the optimum distributor.
Curve 3 shows the results obtained when using a single distributor for all the surfaces to be coated, taking in particular the one which optimises the coating of a sphere having a radius of 104.6 mm, which requires the value of rₐ also being 104.6 mm, and ρ being -10 mm. The diameter of the perimeter of the auxiliary sphere was 70 mm. Once this distributor has been selected, the distance d (between the outlet plate and the lens to be coated) is taken, which minimises the dispersion of thicknesses, in other words, for each sphere radius of the surface to be coated the distance indicated in curve 3 of Fig. 6 has been taken.

### Figure 8.

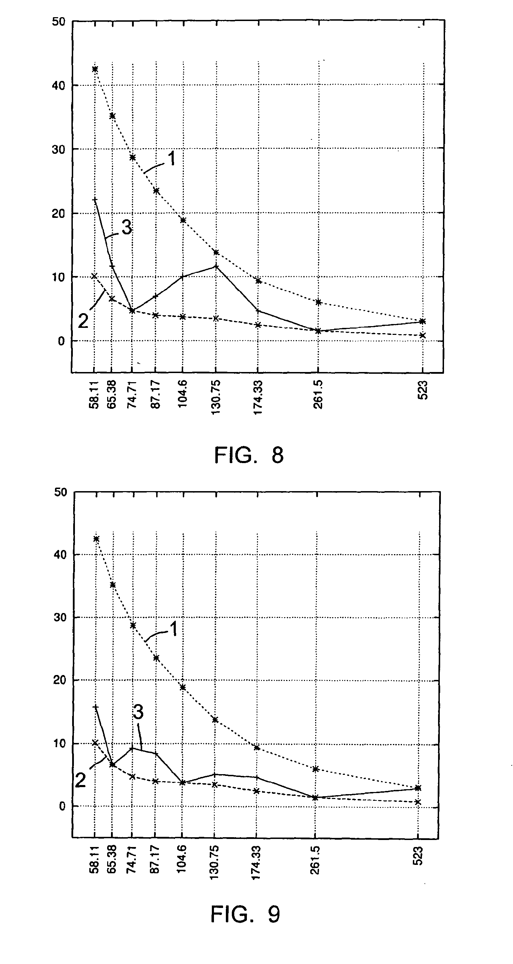

Figure 8 shows a graph similar to that in Figure 7, but in which two distributors have been used. Curves 1 and 2 are the same as those in Figure 7 and curve 3 shows the results obtained when using two distributors for all the surfaces, as follows: the first distributor is the one which optimises the thicknesses for the sphere radius equal to 74.71 mm (obtained with a value of rₐ equal to 74.71 mm, ρ equal to -30 mm and circumference diameter equal to 70 mm) and it has been used to coat surfaces with a sphere radius less than or equal to 104.6 mm, the second distributor is the one which optimises the thicknesses when the sphere radius is equal to 261.5 mm (obtained with a value of rₐ equal to 261.5, ρ equal to 110 mm and circumference diameter equal to 70 mm) and it has been used to coat surfaces having a sphere radius greater than or equal to 130.75 mm. As in the previous case, once the distributor has been chosen for each sphere radius range, the distance d (between the outlet plate and the lens to be coated) has been taken, which minimises the dispersion of the thicknesses, in other words, for each sphere radius on the surface to be coated, the distance indicated in curve 3 in Fig. 6 has been taken.

### Figure 9.

Figure 9 shows another graph similar to that in Figure 7, but wherein three distributors have been used. Once again, curves 1 and 2 are the same as those in Figure 7, and curve 3 shows the results obtained when using three distributors for all the surfaces, as follows: the first distributor is the one which optimises the thicknesses when the sphere radius is equal to 65.38 mm and it has been used to coat surfaces having a sphere radius of 58.11 mm, 65.38 mm, and 74.71 mm; the second distributor optimises the thicknesses when the sphere radius is equal to 104.6 mm and it has been used to coat the surfaces having a sphere radius of 87.17 mm, 104.6 mm and 130.75 mm; and the third distributor optimises the thicknesses when the sphere radius is equal to 262.5 mm and it has been used to coat the surfaces having a sphere radius of 174.33 mm, 262.5 mm and 523 mm. As in the previous cases, in order to obtain "optimum" distributors, the corresponding data in Table 1 has been used. Also in this case, for each sphere radius the distance d (between the outlet plate and the lens to be coated) has been taken, which minimises the dispersion of thicknesses, in other words, for the distance indicated in curve 3 in Fig. 6 has been taken for each sphere radius.

As it can be seen, the dispersion of thicknesses obtained can be improved by considering more distributors. The final selection of the number of distributors to build is mainly determined by logistical and economic factors.

Figures 10 to 12.

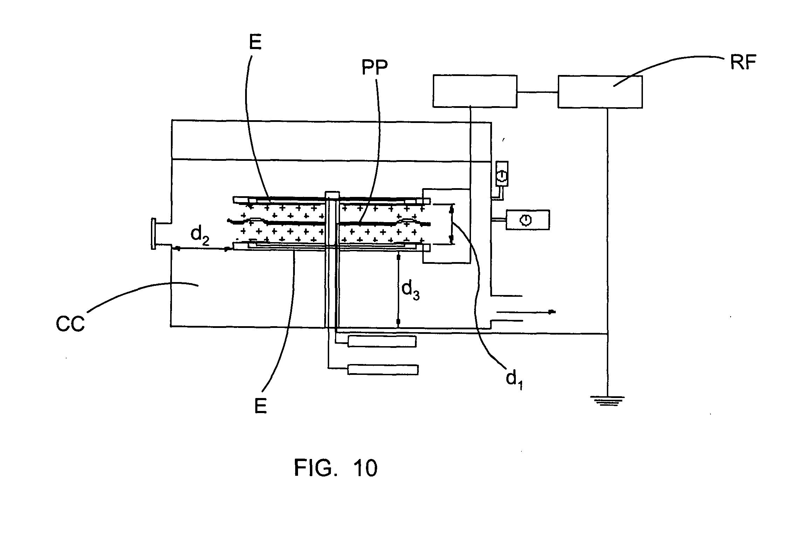

Figure 10 shows a diagram of a lens coating device. It is a PE-CVD type device, suitable for applying both the multiple anti-reflective layers and the hardening coating. To this end, it can deposit layers having thicknesses between 5 and 3000 nanometers with growth speeds, up to 7 nanometers per second. The layers are laid simultaneously on the two surfaces of the ophthalmic lens, using the plasmapolymerisation of organometallic precursors, which are introduced into a vapour phase vacuum chamber, mixed with reactive gases, such as oxygen and/or nitrogen, and/or inert gases, such as argon. In this way, layers of metallic oxides are obtained which enable the desired optical and mechanical properties to be obtained. The device comprises a cylindrical chamber CC with a capacity of approximately 120 I where vacuum is created to pressures below 10⁻³ millibars. The device also has two radio frequency RF generators, operating at 13.56 MHz, and up to 600 W power, and the means for efficiently transmitting the radio frequency signal to electrodes.

Preferably, the device comprises two electrodes E and a lens carrier plate PP arranged between both electrodes E, where at least one of said electrodes E includes at least one of said distributors. In particular, in the example shown in the figures, it is observed that inside chamber CC, two circular electrodes E have been arranged, which are substantially flat and parallel to one another, and separated from one another by a distance d₁. The electrodes E are separated by a distance d₂ from the walls of chamber CC and by a distance d₃ from the base (or roof) of chamber CC, such that d₁ is less than d₂ and d₂ is less than d₃. Between said electrodes E, a flat lens carrier plate PP has been arranged, with the capacity to hold six lenses, each measuring 70 mm in diameter. This configuration makes it possible to correctly confine the plasma between electrodes E.

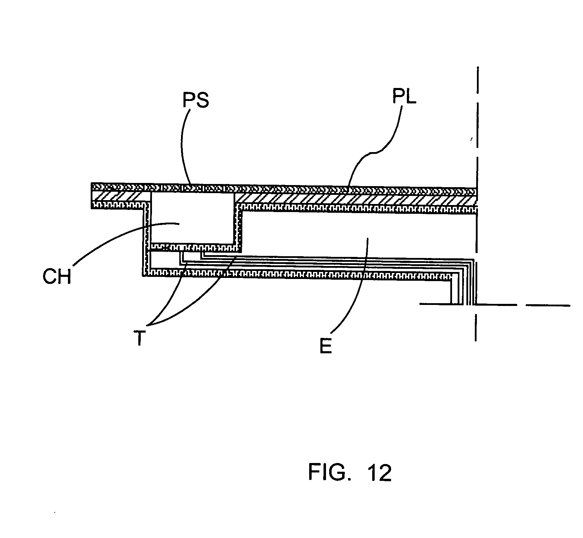

Each electrode E has six flat outlet plates PS corresponding to six gas distributors, each one arranged opposite one of the lenses arranged on the lens carrier plate PP. Figure 12 shows a detail of one of the distributors. It has a homogenization chamber CH which is reached by two tubes T underneath it through which the precursors circulate. The homogenization chamber CH is closed by a plate PL connected to the radio frequency source. In the area of plate PL coinciding with the homogenization chamber CH, the outlet holes are arranged so that this area forms the flat outlet plate PS.

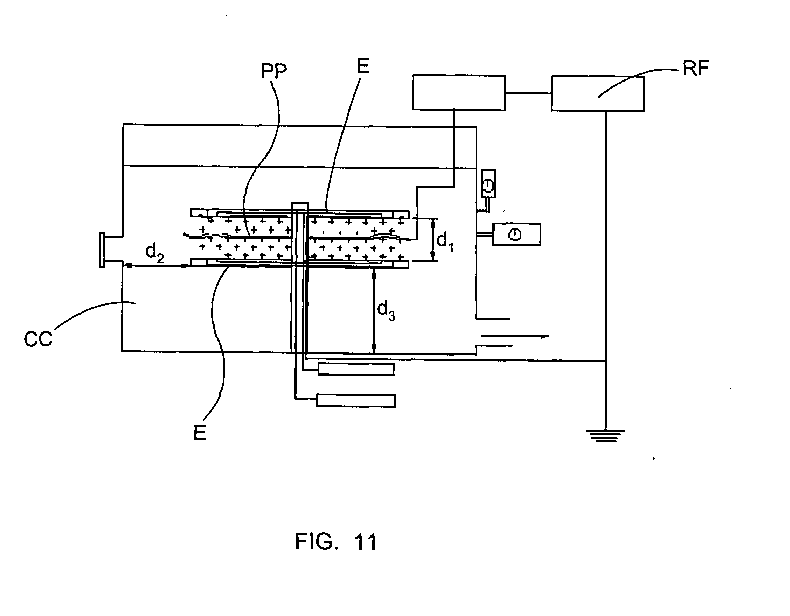

It is possible to choose between different alternatives regarding the connection of the radio frequency source RF. It is possible for both electrodes E to be connected to the radio frequency source RF (see Fig. 10), and there can be a phase displacement between both signals. It is possible that only one of the two electrodes E to be connected to the radio frequency source RF. For its part, the lens carrier plate PP can be connected to the radio frequency source RF (as is the case in the example in Figure 11), it can be a floating power or it can be connected to a variable polarisation. When the lens carrier plate PP is connected to the radio frequency source RF, then the two electrodes E are earth connected. This solution is particularly interesting because it allows a higher coating layer growth speed.

Advantageously, electrodes E are coupled in a capacitive way.

## Claims

1. Gas distributor for coating a lens that defines a surface to be coated and an optical axis, **characterised in that** it comprises a flat outlet plate (PS) with a plurality of outlet holes, where said flat outlet plate (PS) has a plate centre defined and where the distribution of said outlet holes on said plate can be obtained as follows:
[a] defining an auxiliary surface (SA), and positioning said auxiliary surface with respect to said flat outlet plate (PS), where said auxiliary surface (SA) defines an outer perimeter,
[b] positioning first points (P1) on a first flat surface so that they have a constant superficial density of first points (P1),
[c] positioning said first flat surface so that it is in contact with said perimeter and parallel to said flat outlet plate (PS),
[d] for each of said first points (P1):
[d.1] drafting a straight projection line from a projection origin (OP), arranged on said optical axis, and which intersects said first point (P1),
[d.2] extending said straight projection line until it intersects said auxiliary surface (SA), defining a projected point on said auxiliary surface,
[d.3] drafting a folding line perpendicular to said flat outlet plate (PS), from said projected point until it intersects said flat outlet plate, defining a second point (P2),
[e] making an outlet hole in each second point (P2).

2. Distributor according to claim 1, **characterised in that** said auxiliary surface (SA) is suitable for being described by an analytical expression.

3. Distributor according to claim 2, **characterised in that** said auxiliary surface (SA) is a spherical surface.

4. Distributor according to any of the claims 1 to 3, **characterised in that** said auxiliary surface (SA) is a surface that is convex towards said flat outlet plate (PS).

5. Distributor according to any of the claims 1 to 4, **characterised in that** the distance between the surface to be coated and the flat outlet plate (PS) is variable.

6. Distributor according to any of the claims 1 to 5, **characterised in that** the diameter of said outlet holes is greater than 0.5 mm.

7. Distributor according to any of the claims 1 to 6, **characterised in that** between said outlet holes there is a separation comprised between 1 and 10 mm.

8. Distributor according to any of the claims 1 to 7, **characterised in that** said flat outlet plate (PS) is made of a material included in the group made up of silver, copper and aluminium.

9. Distributor according to claim 8, **characterised in that** said flat outlet plate (PS) is made of aluminium.

10. Distributor according to any of the claims 1 to 9, **characterised in that** said flat outlet plate (PS) is made of titanium.

11. Method for manufacturing a lens, **characterised in that** it comprises a coating stage in which a distributor according to any of the claims 1 to 10 is used.

12. Method according to claim 11, **characterised in that** in said coating stage one of said distributors is used simultaneously for each face of said lens.

13. Lens manufactured according to a method according to one of the claims 11 or 12.

14. Lens having a curvature radius less than 350 mm on at least one of the points on its convex face and a coating on its convex face having a maximum thickness difference of between ± 2.5%.

15. CVD type lens coating device, **characterised in that** it comprises at least one distributor according to any of the claims 1 to 10.

16. Device according to claim 15, **characterised in that** it is a PE-CVD type device.

17. Device according to one of the claims 15 or 16, **characterised in that** it comprises at least one radio frequency generator (RF).

18. Device according to any of the claims 15 to 17, **characterised in that** it comprises two electrodes (E) and a lens carrier plate (PP) arranged between both electrodes (E), where at least one of said electrodes (E) includes at least one of said distributors.

19. Device according to claim 18, **characterised in that** said electrodes (E) are connected as condensers.

20. Device according to one of claims 18 or 19, **characterised in that** one of said electrodes (E) is connected to said radio frequency generator (RF).

21. Device according to claim 20, **characterised in that** both electrodes (E) are connected to said radio frequency generator (RF).

22. Device according to any of the claims 17 to 21, **characterised in that** said lens carrier plate (PP) is connected to said radio frequency generator (RF), is connected to a variable polarisation or is at a floating potential.
